Europäisches Patentamt

**European Patent Office**

**Office européen des brevets**

(19)

(11) Veröffentlichungsnummer : **0 047 457**
**B1**

(12) **EUROPÄISCHE PATENTSCHRIFT**

(45) Veröffentlichungstag der Patentschrift :
13.06.84

(21) Anmeldenummer : 81106760.2

(22) Anmeldetag : 29.08.81

(51) Int. Cl.³ : **G 03 F 7/26, B 65 H 5/16**

(54) **Vorrichtung zum Transportieren von Druckplatten.**

(30) Priorität : 08.09.80 DE 3033759

(43) Veröffentlichungstag der Anmeldung :
17.03.82 Patentblatt 82/11

(45) Bekanntmachung des Hinweises auf die Patenterteilung : 13.06.84 Patentblatt 84/24

(84) Benannte Vertragsstaaten :
**CH DE FR GB IT LI NL SE**

(56) Entgegenhaltungen :
**DE-A- 1 807 499**
**GB-A- 1 362 323**
**US-A- 4 067 436**

(73) Patentinhaber : **HOECHST AKTIENGESELLSCHAFT**
**Postfach 80 03 20**
**D-6230 Frankfurt am Main 80 (DE)**

(72) Erfinder : **Radas, Adolf**
**Küferstrasse 39a**
**D-6230 Frankfurt/Main 80 (DE)**

Jouve, 18, rue St-Denis, 75001 Paris, France

## Beschreibung

Die vorliegende Erfindung betrifft eine Vorrichtung zum Transportieren von Druckplatten in einer Verarbeitungsanlage, in der die Druckplatten in der jeweiligen Verarbeitungsstation von einer Ausgangsstellung in eine Endstellung auf einem Verarbeitungstisch gebracht werden.

Die Vorrichtung ist insbesondere für Verarbeitungsanlagen geeignet, in denen beschriftete und bebilderte Druckplatten, die direkt zum Drucken geeignet sind, dadurch hergestellt werden, daß die Druckplatte elektrostatisch aufgeladen, eine Vorlage bildmäßig auf die Druckplatte projiziert wird, die Druckplatte entwickelt, fixiert und entschichtet wird. Zur Durchführung dieser Verarbeitungsschritte durchläuft die Druckplatte die jeweiligen Verarbeitungsstationen. In einzelnen Stationen, wie z. B. der Belichtungs- oder Entwicklungsstation, liegt die Druckplatte auf einem Verarbeitungstisch, der eine Kammer bildet und an seiner Oberseite eine Anzahl von Löchern aufweist. Die Kammer ist über eine Saugleitung mit einer Vakuumpumpe verbunden. Dadurch wird die auf dem Verarbeitungstisch liegende Druckplatte durch Erzeugen eines Vakuums während der Verarbeitung auf dem Tisch festgehalten. Nach Beendigung des jeweiligen Verarbeitungsschrittes wird die Druckplatte zur nächsten Verarbeitungsstation transportiert.

In der deutschen Patentanmeldung P 30 25 201.8 wird eine Vorrichtung für den Transport und die Positionierung von Druckplatten, die in einem Magazin gestapelt sind, zu einer Belichtungsstation beschrieben. Diese Vorrichtung weist einen verfahrbaren Hubzylinder auf, der an seiner aus- und einfahrbaren Zylinderstange Saugelemente aufweist, mit denen die Druckplatten aus einem senkrecht zur Transportrichtung stehenden Magazin zu einer nach oben geöffneten Greifereinrichtung transportiert werden, die die Druckplatten in die Horizontallage schwenkt und in Richtung Belichtungsstation transportiert. Diese Vorrichtung ist jedoch nicht geeignet, eine bereits in der Horizontallage auf einem Verarbeitungstisch in einer Ausgangsstellung befindliche Druckplatte in eine gewünschte Endstellung zu verschieben, wobei das in Transportrichtung weisende Ende der Druckplatte, unabhängig vom Format der Druckplatte, immer die gleiche Endstellung erreicht.

Aufgabe der vorliegenden Erfindung ist es, eine Vorrichtung der eingangs genannten Art zu schaffen, durch die die Druckplatten unabhängig von ihrem Format mit ihren in Transportrichtung weisenden Enden immer dieselbe Endstellung erreichen, der Verarbeitungstisch sowie seine seitlichen Bereiche von Transportelementen freigehalten werden und die in Verarbeitungsanlagen für Druckplatten bereits vorhandene Pneumatik zum Transport der Druckplatten ausgenutzt wird.

Diese Aufgabe wird durch die in Anspruch 1 angegebene Vorrichtung gelöst.

Die Vorrichtung ist insbesondere für die Entwicklungsstation geeignet, in der die Druckplatte durch eine beliebige Transporteinrichtung in die Ausgangsstellung auf dem Entwicklungstisch befördert wird. Nachdem die Druckplatte durch die erfindungsgemäße Vorrichtung in die Endstellung auf dem Entwicklungstisch gebracht ist, wird Vakuum an den Entwicklungstisch angelegt und die Druckplatte im angesaugten Zustand mit dem Entwicklungstisch durch die Entwicklungsstation transportiert.

Die Einrichtung zum Heben und Senken hebt das Schubelement, bevor die Druckplatte in die Ausgangsstellung gebracht wird, auf ein Niveau oberhalb der Transportebene der Druckplatte, so daß die Druckplatte ungehindert in die Ausgangsstellung transportiert werden kann, bzw. senkt das Schubelement, nachdem die Druckplatte die Ausgangsstellung erreicht hat, auf ein Niveau unterhalb der Transportebene der Druckplatte, so daß das Schubelement bei Einsetzen der Bewegung der Zylinderstange in Transportrichtung der Druckplatte in Eingriff mit der Druckplatte kommt.

Das Schubelement kann an der aus- und einfahrbaren Zylinderstange in vertikaler Richtung verschiebbar angebracht sein, so daß es von der Einrichtung zum Heben und Senken in vertikaler Richtung bewegt werden kann, ohne daß sich die Lage der Zylinderstange und des Zylinders in vertikaler Richtung verändern.

In einer bevorzugten Ausführungsform ist das Schubelement jedoch nicht verschiebbar an der Zylinderstange befestigt und der Zylinder um eine senkrecht zur Transportrichtung der Druckplatte verlaufende Achse drehbar gelagert. In diesem Fall werden bei Betätigung der Einrichtung zum Heben und Senken mit dem Schubelement Zylinder und Zylinderstange um einen entsprechenden Betrag um die Achse gedreht.

Vorzugsweise ist an der Zylinderstange eine Frontplatte vorgesehen, die unten an ihren beiden Seiten als Winkel ausgebildete Schubelemente trägt. In der Frontplatte ist ferner eine Ausnehmung, in die ein Arm der Einrichtung zum Heben und Senken eingreift, wenn die Zylinderstange in Richtung dieser Einrichtung bewegt wird.

Der vom Druckplattenende bei Erreichen der Endstellung zu betätigende erste Schalter kann an der Stelle angeordnet sein, an der das in Transportrichtung weisende Ende der Druckplatte bei Erreichen der Endstellung liegen soll, und wird von diesem Ende der Druckplatte betätigt. In diesem Fall ist der Schalter unabhängig von der Länge der Druckplatte fest installiert. Der Schalter kann jedoch auch durch das entgegen der Transportrichtung weisende Ende der Druckplatte betätigt werden. In diesem Fall ist der Schalter beweglich installiert und wird bei Einstellung der Druckplattenlänge an der Anlage automatisch bei kürzeren Druckplatten in Transportrichtung der Anlage verschoben bzw. bei längeren Druckplatten entsprechend entgegen der Transportrichtung verschoben. In beiden Fällen erreicht das in Transportrichtung weisende Ende der Druckplatte, unabhängig vom Format, immer dieselbe Endstellung.

In einer bevorzugten Ausführungsform ist die Einrichtung zum Heben und Senken des Schubelements ein zweiter pneumatisch betriebener Zylinder.

Wie bereits weiter oben erwähnt, kann die Druckplatte durch ein beliebiges Transportmittel in die Ausgangsstellung befördert werden. Dieses Transportmittel kann, sofern es nur dann läuft, wenn eine Druckplatte von ihm befördert wird, die Einrichtung zum Heben und Senken sowie den ersten Zylinder steuern. So kann durch das Abstellen des Transportmittels, d. h. wenn die Druckplatte die Ausgangsstellung auf dem Verarbeitungstisch erreicht hat, die Einrichtung zum Heben und Senken betätigt werden, wodurch das Schubelement auf das Niveau unterhalb der Transportebene der Druckplatte gesenkt wird und die Bewegung der Zylinderstange in Transportrichtung der Druckplatte gestartet wird, wodurch das Schubelement in Eingriff mit der Druckplatte kommt und diese in die Endstellung schiebt. Nachdem die Bewegung der Zylinderstange durch Betätigung des ersten Schalters durch das Druckplattenende in die entgegengesetzte Richtung umgesteuert wurde, kommt das Schubelement wiederum in Eingriff mit der Einrichtung zum Heben und Senken. Bei Anstellen des Transportmittels, das die nächste Druckplatte in die Ausgangsstellung bringt, wird die Einrichtung zum Heben und Senken betätigt, wodurch das Schubelement angehoben und der Transportweg für diese nächste Druckplatte freigegeben wird.

In einer bevorzugten Ausführungsform sind jedoch Schalter vorhanden, die durch die Druckplatte bzw. das Schubelement oder andere Teile an der Zylinderstange betätigt werden und die Einrichtung zum Heben und Senken des Schubelements sowie den Start und das Ende der Bewegung der Zylinderstange auslösen. Dies wird im folgenden anhand des Ausführungsbeispiels und der Zeichnung näher erläutert.

Es zeigen :

Figur 1 eine Seitenansicht eines Ausführungsbeispiels,

Figur 2 ein Diagramm über den zeitlichen Ablauf der Bewegungen der Zylinderstangen des in Fig. 1 gezeigten Ausführungsbeispiels und

Figur 3 ein schematisches Schaltbild für die Druckluftführung des in Fig. 1 gezeigten Ausführungsbeispiels.

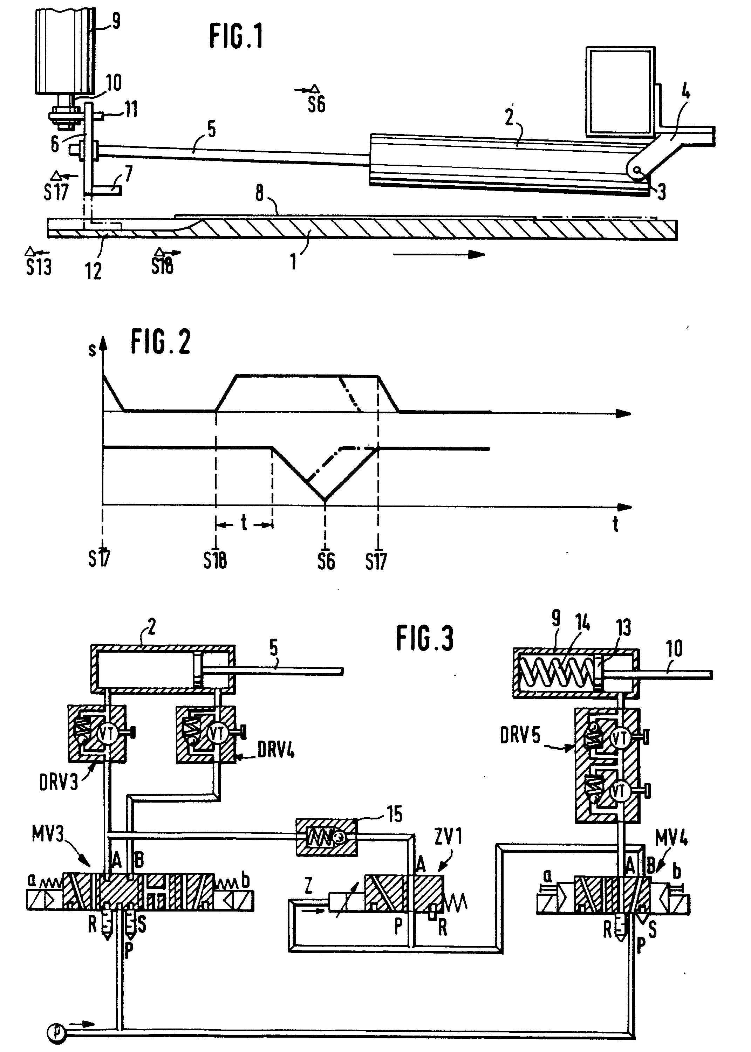

Oberhalb des Entwicklungstisches 1, der in Längsrichtung der Anlage hin- und hergefahren werden kann, ist der Zylinder 2 angeordnet. Er wird um die Achse 3 drehbar von einer Halteeinrichtung 4 gehalten. Am vorderen Ende der Zylinderstange 5 ist eine Frontplatte 6 befestigt, an deren beiden Seiten Schubelemente 7 angebracht sind, die die Form von Winkeln haben, deren parallel zur Transportrichtung der Druckplatte (vgl. Pfeil in Fig. 1) verlaufende Schenkel in Richtung des zu schiebenden Druckplattenendes weisen. Oberhalb des Bereiches, in dem sich die Frontplatte 6 befindet, bevor sie durch die einfahrende Zylinderstange 5 in Richtung der in der Ausgangsstellung befindlichen Druckplatte 8 bewegt wird, ist ein zweiter Zylinder 9 angeordnet (in Fig. 1 nur teilweise dargestellt). Die Zylinderstange 10 dieses Zylinders 9 weist einen in Transportrichtung der Druckplatte weisenden Arm 11 auf, der in eine in Fig. 1 nicht zu sehende Ausnehmung in der Frontplatte 6 eingreift, wenn die Frontplatte 6 durch die Zylinderstange 5 in Richtung des Zylinders 9 bewegt wird. Die Druckplatte 8 ist in Fig. 1 in ihrer Ausgangsstellung dargestellt. Sie ragt mit ihrem hinteren Ende über den Entwicklungstisch 1 hinaus. Am Entwicklungstisch sind Führungen 12 für die Schubelemente 7 angebracht. Die Endstellung der Druckplatte 8 ist in Fig. 1 gestrichelt dargestellt.

Der Schalter $S_6$ ist verschiebbar angeordnet. Er wird bei Einstellung des Druckplattenformats in der Verarbeitungsanlage in die entsprechende Stellung verschoben. Bei längeren Druckplatten als der in Fig. 1 gezeigten Druckplatte 8 ist er in eine weiter links liegende Stellung als in Fig. 1 gezeigt verschoben. Der Schalter $S_6$ spricht auf das hintere Druckplattenende an und steuert die Bewegung der Zylinderstange 5 um.

Der Schalter $S_{17}$ ist fest unterhalb des Zylinders 9 angeordnet. Bei Betätigung des Schalters $S_{17}$ durch die Frontplatte 6 wird die Bewegung der Zylinderstange 5 des Zylinders 2 entgegen der Transportrichtung der Druckplatte gestoppt sowie die Zylinderstange 10 des Zylinders 9 eingefahren, wodurch die Frontplatte 6 mit den Schubelementen 7 in die in Fig. 1 gezeigte Stellung gehoben wird.

Der Schalter $S_{18}$ ist fest unterhalb der Transportebene der Druckplatte 8 angeordnet. Bei seiner Betätigung durch das hintere Druckplattenende wird die Zylinderstange 10 des Zylinders 9 ausgefahren und damit die Frontplatte 6 mit den Schubelementen 7 in die in Fig. 1 gestrichelt gezeichnete Stellung gesenkt. Gleichzeitig wird durch die Betätigung des Schalters $S_{18}$ nach Ablauf einer Zeit t die Zylinderstange 5 des Zylinders 2 eingefahren und damit durch die Schubelemente 7 die Druckplatte 8 in die gewünschte Endstellung transportiert.

In Fig. 3 sind mit P die Zuleitungen für die Druckluft bezeichnet. Das Magnetventil MV3 für den Zylinder 2 hat vier Stellungen. Die erste Stellung (von links in Fig. 3) wird erreicht, wenn an das elektrische Ventil MV3a Spannung gelegt wird, die zweite Stellung, wenn an keines der elektrischen Ventile MV3a und MV3b Spannung angelegt ist (die in Fig. 3 gezeigte Stellung des Magnetventils MV3a), die dritte Stellung, wenn an beide elektrische Ventile MV3a und MV3b Spannung angelegt ist und die vierte Stellung, wenn an das elektrische Ventil MV3b Spannung angelegt ist. Zwischen den Anschlüssen A und B und den Kammern des Zylinders 2 sind jeweils Drosselrückschlagventile DRV3 und DRV4 vorgesehen. Mit R und S sind Entlüftungsöffnungen bezeichnet.

Das Impulsmagnetventil MV4 für den Zylinder 9 hat zwei Stellungen. Bei einem Spannungsstoß auf das elektrische Ventil MV4a wird die erste Stellung und bei einem Spannungsstoß auf das elektrische Ventil MV4b die zweite Stellung (die in Fig. 3 gezeigte Stellung des Impulsmagnetventils MV4) erreicht. Die Entlüftungsöffnung S ist hier geschlossen. Mit A ist der Anschluß zum Zylinder 9 bezeichnet und mit DRV5 das dem Zylinder 9 zugeordnete Drosselrückschlagventil. Der Kolben 13 des Zylinders 9 ist gegen eine Feder 14 abgestützt.

Zwischen den Anschluß B am Impulsmagnetventil MV4 und die Leitung zwischen Anschluß A am Magnetventil MV3 und Drosselrückschlagventil DRV3 ist ein Zeitverzögerungsventil ZV1 geschaltet. Dieses hat zwei Stellungen. In der in Fig. 3 gezeigten Stellung ist Anschluß B des Impulsmagnetventils MV4 über das Zeitverzögerungsventil ZV1 mit der Leitung zwischen Anschluß A am Magnetventil MV3 und dem Drosselrückschlagventil DRV3 verbunden. In der zweiten Stellung ist die Verbindung unterbrochen, da die Entlüftungsöffnung R geschlossen ist. In der Leitung vom Anschluß A des Zeitverzögerungsventils ZV1 zum Zylinder 2 ist ein Kugelrückschlagventil 15 vorgesehen.

Die Arbeitsweise der erfindungsgemäßen Vorrichtung wird im folgenden unter Bezugnahme auf die Figuren 1 bis 3 beschrieben.

Die im folgenden beschriebenen Abläufe treten nur ein, wenn die gesamte Anlage abgestellt war und eingeschaltet wird. In diesem Fall wird an das elektrische Ventil MV3a Spannung gelegt, das Magnetventil MV3 befindet sich somit in seiner ersten Stellung (von links). Die Druckleitung P ist mit dem Anschluß A und der Anschluß B mit der Entlüftungsöffnung S verbunden. Die Zylinderstange 5 fährt somit aus in Richtung Zylinder 9. Wenn die Frontplatte 6 der Zylinderstange 5 die in Fig. 1 gestrichelt gezeigte Stellung erreicht, kommt sie in Eingriff mit dem Arm 11 an der Zylinderstange 10 des Zylinders 9 und betätigt außerdem den Schalter $S_{17}$. Dadurch wird das elektrische Ventil MV3a spannungslos, das Magnetventil MV3 schaltet in die in Fig. 3 gezeigte Stellung, d. h. die Ventildurchgänge sind gesperrt, und die Bewegung der Zylinderstange 5 wird gestoppt. Durch die Betätigung von Schalter $S_{17}$ erfolgt ferner ein Spannungsstoß an das elektrische Ventil MV4a, wodurch das Impulsmagnetventil MV4 in die linke Stellung geschaltet wird. Die Druckleitung P ist dann mit dem Anschluß A verbunden, der Zylinder 9 wird mit Druckluft beaufschlagt und damit die Zylinderstange 10 eingefahren, wobei sie die Feder 14 vorspannt. Die mit dem Arm 11 in Eingriff stehende Frontplatte 6 mit den Schubelementen 7 wird beim Einfahren der Zylinderstange 10 hochgehoben, wobei der Zylinder 2 um die Achse 3 gedreht wird. Diese Stellung der Zylinder 2 und 9 sowie der Frontplatte 6 mit den Schubelementen 7 ist in Fig. 1 gezeigt. Der Transportweg für die Druckplatte ist frei. Gleichzeitig mit dem Einschalten der Verarbeitungsanlage wird der Entwicklungstisch 1 entgegen der Transportrichtung der Druckplatte bewegt. Wenn der Entwicklungstisch 1 den Schalter $S_{13}$ betätigt, hält der Entwicklungstisch an und hat die in Fig. 1 gezeigte Stellung. Die bis jetzt beschriebenen Abläufe gelten nur, wenn die Anlage eingeschaltet wird.

Die im folgenden beschriebenen Abläufe wiederholen sich jeweils, wenn Druckplatten in die Anlage eingeführt werden. Eine in die Verarbeitungsanlage eingeführte Druckplatte 8 wird von der Belichtungsstation durch nicht gezeigte Transportmittel unterhalb der Schubelemente 7 in die in Fig. 1 gezeigte Stellung transportiert. Der Schalter $S_{18}$ spricht an, wenn er von der Druckplatte 8 freigegeben wird, d. h. wenn das hintere Ende der Druckplatte 8 den Schalter $S_{18}$ passiert hat. Die Betätigung des Schalters $S_{18}$ löst einen Spannungsstoß am elektrischen Ventil MV4b aus, wodurch das Impulsmagnetventil MV4 in die in Fig. 3 gezeigte Stellung geschaltet wird. Dadurch entweicht die Druckluft aus dem Zylinder 9 über die Entlüftungsöffnung R. Die gespannte Feder 14 drückt auf den Kolben 13 des Zylinders 9, wodurch die Zylinderstange 10 ausfährt und damit die Frontplatte 6 mit den Schubelementen 7 in die in Fig. 1 gestrichelt gezeigte Stellung gesenkt wird. Die Schubelemente 7 liegen auf den Führungen 12 am Entwicklungstisch 1 auf. Wenn das Impulsmagnetventil MV4 in die in Fig. 3 gezeigte Stellung geschaltet wird, wird gleichzeitig das Zeitverzögerungsventil ZV1 in die in Fig. 3 gezeigte Stellung geschaltet. Dadurch ist die Druckleitung P über das Zeitverzögerungsventil ZV1 mit der Leitung zwischen Anschluß A am Magnetventil MV3 und Drosselrückschlagventil DRV3 verbunden. Die linke Kammer des Zylinders 2 wird mit Druckluft beaufschlagt. Nach einer bestimmten Zeit, wenn der am Zeitverzögerungsventil ZV1 eingestellte Druck durch Zuführung von Druckluft über die Leitung Z erreicht ist, schaltet das Zeitverzögerungsventil ZV1 in die linke Stellung, wodurch die Zuführung von Druckluft über das Impulsmagnetventil MV4 zum Zylinder 2 unterbrochen wird und der Anschluß A des Zeitverzögerungsventils ZV1 durch die geschlossene Entlüftungsöffnung R geschlossen wird.

Durch das Zeitverzögerungsventil ZV1 wird erreicht, daß im Zylinder 2, auch wenn längere Zeit keine Druckplatte in die Anlage eingeführt wurde, der dadurch bedingte Druckabfall im Zylinder 2 beseitigt wird und immer ein ausreichendes Luftpolster vorhanden ist, gegen das die Zylinderstange 5 mit dem Kolben bewegt wird, wenn eine neue Druckplatte 8 von der Ausgangs- in die Endstellung transportiert wird. Eine ruckartige Bewegung der Druckplatte, die eine genaue Positionierung in der Endstellung nicht erlauben würde, wird damit vermieden.

Wenn eine bestimmte Zeit t nach Betätigung des Schalters $S_{18}$ abgelaufen ist, wird Spannung an das elektrische Ventil MV3b gelegt, wodurch das Magnetventil MV3 in die vierte Stellung (rechte Stellung) geschaltet wird. In dieser Stellung wird die Zuleitung P für Druckluft mit dem Anschluß B am Magnetventil MV3 verbunden, während der Anschluß A mit der Entlüftungsöffnung R verbunden ist. Über das Drosselrückschlagventil DRV4 wird dem Zylinder 2 Druckluft zugeführt, die Zylinderstange 5 gegen das Luftpolster in der linken Kammer des Zylinders 2 bewegt, wodurch, wie oben bereits erläutert wurde, ein ruhiger Zylinderlauf gewährleistet ist. Beim Einfahren der Zylinderstange 5 wird die Frontplatte 6 mit den Schubelementen 7 in Richtung Druckplatte 8 bewegt. Die Schubelemente 7 gleiten auf den Führungen 12 hoch, wodurch die horizontalen Schenkel der Schubelemente 7 unter das Druckplattenende gleiten, das dann auf ihnen liegt. Die Druckplatte wird in die in Fig. 1 gestrichelt gezeichnete Stellung verschoben.

Der Schalter $S_6$ wurde durch die Einstellung der Druckplattenlänge an der Anlage vorher in die entsprechende Lage verschoben. Wenn das hintere Ende der Druckplatte 8 den Schalter $S_6$ freigibt, wird dieser betätigt. Dadurch wird das elektrische Ventil MB3b spannungslos und Spannung an das elektrische Ventil MV3a gelegt. Das Magnetventil MV3 wird in die erste Stellung geschaltet, wodurch die Bewegung der Zylinderstange 5 umgesteuert wird. Die Zylinderstange 5 fährt aus, wodurch die Frontplatte 6 mit den Schubelementen 7 entgegen der Transportrichtung der Druckplatte 8 bewegt wird. Dadurch gleiten die Schubelemente 7 unter dem hinteren Druckplattenende heraus, und die Druckplatte liegt in der gestrichelt gezeichneten Stellung. An den Entwicklungstisch 1 wird Vakuum gelegt und die Druckplatte 8 angesaugt.

Wenn die Frontplatte 6 den Schalter $S_{17}$ erreicht und ihn betätigt, wird das elektrische Ventil MV3a spannungslos ; da beide Ventile Mv3a und MV3b spannungslos sind, wird das Magnetventil MV3 in die in Fig. 3 gezeigte Stellung geschaltet, in der die Ventildurchgänge gesperrt sind. Die Zylinderstange 5 bleibt stehen. Gleichzeitig erfolgt durch die Betätigung des Schalters $S_{17}$ ein Spannungsstoß an das elektrische Ventil MV4a, wodurch das Magnetventil MV4 in die linke Stellung geschaltet wird, in der der Zylinder 9 mit Druckluft beaufschlagt wird, die Zylinderstange 10 einfährt und die Frontplatte 6, die bei der Bewegung in Richtung Schalter $S_{17}$ in Eingriff mit dem Arm 11 an der Zylinderstange 10 gekommen war, hochgehoben wird. Die Frontplatte 6 mit den Schubelementen 7 und der Zylinder 2 haben wieder die in Fig. 1 gezeigte Stellung. Die Vorrichtung ist bereit für die Einführung der nächsten Druckplatte, wobei die oben beschriebenen Abläufe der Betätigung des Schalters $S_{18}$ sich wiederholen.

Die in der Endstellung befindliche vorhergehende Druckplatte, die auf dem Entwicklungstisch 1 angesaugt ist, wird mit dem Entwicklungstisch 1 in Transportrichtung der Druckplatte weiterbewegt.

In Fig. 2 ist die Zeit t gegen die Ausfahrwege s der Zylinderstangen 5 und 10 aufgetragen. Die obere Kurve zeigt den Bewegungsablauf für die Zylinderstange 10 des Zylinders 9, die untere Kurve den Bewegungsablauf für die Zylinderstange 5 des Zylinders 2. Bevor der Schalter $S_{18}$ vom hinteren Druckplattenende betätigt wird, ist die Zylinderstange 10 in eingefahrener Stellung und die Zylinderstange 5 in ausgefahrener Stellung (Stellung von Fig. 1). Bei Betätigung von $S_{18}$ wird die Zylinderstange 10 ausgefahren (gestrichelt gezeigte Stellung in Fig. 1) und bleibt in dieser Stellung bis $S_{17}$ von der Frontplatte 6 betätigt wird. Nach Ablauf der Zeit t wird die Zylinderstange 5 eingefahren, und bei Betätigung von Schalter $S_6$ durch das hintere Druckplattenende wird die Bewegung umgesteuert und die Zylinderstange 5 wieder ausgefahren. Bei Betätigung des Schalters $S_{17}$ durch die Frontplatte 6 wird die Zylinderstange 10 eingefahren und die Ausfahrbewegung der Zylinderstange 5 beendet. Die in Fig. 2 gestrichelt gezeichneten Kurven für die Zylinderstangen 5 und 10 zeigen den Verlauf für eine längere Druckplatte, d. h. wenn $S_6$ nach links verschoben ist und die Bewegung der Zylinderstange 5 entsprechend früher umgesteuert wird. $S_{17}$ wird dann ebenfalls nach einer kürzeren Zeit von der Frontplatte 6 betätigt und damit die Ausfahrbewegung der Zylinderstange 5 früher beendet und die Zylinderstange 10 früher eingefahren.

**Ansprüche**

1. Vorrichtung zum Transportieren von Druckplatten in einer Verarbeitungsanlage, in der die Druckplatten in der jeweiligen Verarbeitungsstation von einer Ausgangsstellung in eine Endstellung auf einem Verarbeitungstisch gebracht werden, dadurch gekennzeichnet, daß oberhalb der Ebene, in der die Druckplatte (8) in ihrer Ausgangsstellung auf dem Verarbeitungstisch (1) liegt, ein pneumatisch betriebener Zylinder (2) angeordnet ist, daß an der in Längsrichtung der Anlage aus- und einfahrbaren Zylinderstange (5) des Zylinders (2) mindestens ein Schubelement (7) angebracht ist, das die Druckplatte (8) bei Betätigung des Zylinders (2) von der Ausgangsstellung in die Endstellung transportiert, und daß eine Einrichtung (9 bis 11) zum Heben und Senken des Schubelements (7) von einem Niveau unterhalb der Transportebene der Druckplatte (8) auf ein Niveau oberhalb der Transportebene der Druckplatte (8) bzw. umgekehrt, und ein vom in Transportrichtung weisenden Druckplattenende bei Erreichen der Endstellung zu betätigender Schalter ($S_6$) vorgesehen ist, der die Umsteuerung der Bewegung der Zylinderstange (5) auslöst.

2. Vorrichtung nach Anspruch 1, dadurch gekennzeichnet, daß der Verarbeitungstisch (1) in Längsrichtung der Anlage hin- und herfahrbar ist.

3. Vorrichtung nach Anspruch 1 oder 2, dadurch gekennzeichnet, daß der Zylinder (2) um eine senkrecht zur Transportrichtung der Druckplatte (8) verlaufende Achse (3) drehbar gelagert ist.

4. Vorrichtung nach Anspruch 3, dadurch gekennzeichnet, daß an der Zylinderstange (5) des Zylinders (2) eine Frontplatte (6) befestigt ist, die unten an beiden Seiten Schubelemente (7) trägt und eine Ausnehmung aufweist, in die ein Arm (11) der Einrichtung (9 bis 11) zum Heben und Senken des Schubelements (7) eingreift.

5. Vorrichtung nach einem der Ansprüche 1 bis 4, dadurch gekennzeichnet, daß die Einrichtung zum Heben und Senken (9 bis 11) ein zweiter pneumatisch betriebener Zylinder (9) ist, an dessen Zylinderstange (10) der Arm (11) angeordnet ist.

6. Vorrichtung nach einem der Ansprüche 1 bis 5, dadurch gekennzeichnet, daß ein zweiter Schalter (S$_{18}$) vorgesehen ist, der von dem entgegen der Transportrichtung weisenden Druckplattenende bei Erreichen der Ausgangsstellung betätigt wird, der das Senken des Schubelements (7) durch die Einrichtung (9 bis 11) zum Anheben und Senken und die Bewegung der Zylinderstange (5) des ersten Zylinders (2) in Transportrichtung der Druckplatte auslöst.

7. Vorrichtung nach Anspruch 6, dadurch gekennzeichnet, daß ein als Folge der Betätigung des zweiten Schalters (S$_{18}$) geschaltetes Zeitverzögerungsventil (ZV1) vorgesehen ist, über das der erste Zylinder (2) mit Druckluft beaufschlagt wird, bevor die Bewegung der Zylinderstange (5) entgegen dem entstandenen Luftpolster in Transportrichtung der Druckplatte einsetzt.

8. Vorrichtung nach einem der Ansprüche 1 bis 7, dadurch gekennzeichnet, daß ein von dem Schubelement (7) oder Teilen (6), an denen es angebracht ist, zu betätigender dritter Schalter (S$_{17}$) vorgesehen ist, der die Beendigung der Bewegung der Zylinderstange (5) des Zylinders (2) entgegen der Transportrichtung der Druckplatte sowie das Anheben des Schubelements (7) durch die Einrichtung (9 bis 11) zum Anheben und Senken auslöst.

**Claims**

1. Device for transporting printing plates in a processing unit, in which the printing plates are brought in the processing station in question from a starting position into a final position on a processing table, characterised in that a pneumatically operated actuator (2) is located above the plane in which the printing plate (8) rests in its starting position on the processing table (1), in that at least one pusher-element (7) being attached to the actuating rod (5) of the actuator (2), said rod being capable of extension and retraction in the longitudinal direction of the unit, said pusher-element is transporting the printing plate (8) from the starting position into the final position when the actuator (2) is operated, and in that a device (9 to 11) is provided for raising the pusher-element (7) from a level beneath the transport plane of the printing plate (8) to a level above the transport plane of the printing plate (8), and for lowering said element in the opposite sense, and in that a switch (S$_6$) is provided, which is to be operated by the end of the printing plate which directs in the transport direction when the final position is reached and which initiates the reversal of the movement of the actuating rod (5).

2. Device as claimed in claim 1, characterised in that the processing table (1) can be moved backwards and forwards in the longitudinal direction of the unit.

3. Device as claimed in claim 1 or 2, characterised in that the actuator (2) is mounted so that it can rotate about a shaft (3) running vertically to the transport direction of the printing plate (8).

4. Device as claimed in claim 3, characterised in that a front plate (6) is fastened to the actuating rod (5) of the actuator (2), said plate carrying at the bottom pusher-elements (7) on both sides and having a recess into which an arm (11) of the device (9 to 11) for raising and lowering the pusher-element (7) is engaged.

5. Device as claimed in one of claims 1 to 4, characterised in that the raising and lowering device (9 to 11) is a second pneumatically operated actuator (9), the arm (11) being located on the actuating rod (10) thereof.

6. Device as claimed in one of claims 1 to 5, characterised in that a second switch (S$_{18}$) is provided, which is operated by that end of the printing plate which points in the direction opposite to the transport direction, when the starting position is reached, said switch initiates the lowering of the pusher-element (7), by means of the raising and lowering device (9 to 11), and the movement of the actuating rod (5) of the first actuator (2) in the transport direction of the printing plate.

7. Device as claimed in claim 6, characterised in that a delayed-action valve (ZV1) is provided, which is actuated as a consequence of the operation of the second switch (S$_{18}$) and via which compressed air is admitted to the first actuator (2) before the movement of the actuating rod (5) begins, against the aircushion which has formed, in the transport direction of the printing plate.

8. Device as claimed in one of claims 1 to 7, characterised in that a third switch (S$_{17}$) is provided, which is intended to be operated by the pusher-element (7) or by parts (6) to which this element is attached, said switch initiates the termination of the movement of the actuating rod (5) of the actuator (2) in opposition to the transport direction of the printing plate, as well as the lifting of the pusher-element (7) by means of the raising and lowering device (9 to 11).

**Revendications**

1. Dispositif de manutention de plaques d'impression dans une installation de traitement dans laquelle les plaques, à chaque poste de traitement, sont amenées d'une position de départ à une position finale sur une table de traitement, caractérisé en ce qu'un cylindre pneumatique (2) est placé au-dessus du plan dans lequel la plaque d'impression (8) se trouve dans sa position de départ sur la table de traitement (1), en ce qu'au moins un élément de poussée (7) est monté sur la tige de piston (5) du cylindre (2) qui entre et sort dans la direction longitudinale de l'installation, cet élément de poussée (7) amenant la plaque d'impression (8) de sa position de départ à sa position finale quand le cylindre (2) est actionné, et en ce qu'il comprend un dispositif (9 à 11) servant à relever et à abaisser l'élément de poussée (7) d'un niveau situé au-dessous du plan de déplacement de la plaque d'impression (8) à un niveau situé au-dessus de ce plan et inversement, ainsi qu'un interrupteur ($S_6$) actionné par l'extrémité de la plaque d'impression (8) qui se trouve du côté du déplacement lorsqu'elle atteint sa position finale, interrupteur ($S_6$) qui déclenche l'inversion du mouvement de la tige de piston (5).

2. Dispositif selon la revendication 1, caractérisé en ce que la table de traitement (1) peut faire des va-et-vient dans la direction longitudinale de l'installation.

3. Dispositif selon la revendication 1 ou 2, caractérisé en ce que le cylindre (2) est monté de façon à pouvoir pivoter sur un axe (3) perpendiculaire à la direction du déplacement de la plaque d'impression (8).

4. Dispositif selon la revendication 3, caractérisé en ce qu'une plaque transversale (6) est fixée sur la tige de piston (5) du cylindre (2), plaque (6) qui porte en bas, des deux côtés, des éléments de poussée (7) et qui présente une échancrure dans laquelle s'engage un bras (11) du dispositif (9 à 11) servant à relever et à abaisser l'élément de poussée (7).

5. Dispositif selon l'une des revendications 1 à 4, caractérisé en ce que le dispositif (9 à 11) servant à relever et à abaisser est un deuxième cylindre pneumatique (9) sur la tige (10) de piston duquel est monté le bras (11).

6. Dispositif selon l'une des revendications 1 à 5, caractérisé en ce qu'il possède un deuxième interrupteur ($S_{18}$), qui est actionné par l'extrémité de la plaque d'impression (8) située du côté opposé à celui du déplacement lorsqu'elle atteint sa position de départ et qui déclenche la descente de l'élément de poussée (7) par le dispositif (9 à 11) servant à relever et à abaisser l'élément de poussée (7) et le mouvement de la tige de piston (5) du premier cylindre (2) dans le sens du déplacement de la plaque d'impression (8).

7. Dispositif selon la revendication 6, caractérisé en ce qu'une soupape retardatrice (ZV1) actionnée par suite de l'actionnement du deuxième interrupteur ($S_{18}$) envoie de l'air comprimé au premier cylindre (2) avant que le déplacement de la tige de piston (5) commence dans le sens du déplacement de la plaque d'impression (8) en surmontant le tampon d'air qui s'est formé.

8. Dispositif selon l'une des revendications 1 à 7, caractérisé en ce qu'un troisième interrupteur ($S_{17}$), actionné par l'élément de poussée (7) ou par des pièces (6) sur lesquelles il est monté, déclenche l'achèvement du mouvement de la tige de piston (5) du cylindre (2) en sens opposé à celui du déplacement de la plaque d'impression (8) ainsi que le relèvement de l'élément de poussée (7) par le système (9 à 11) servant à le relever et à l'abaisser.

# FIG.1

# FIG.2

# FIG.3